# FASCICULE DE BREVET EUROPEEN

(11) **EP 1 440 326 B1**
(45) Date de publication et mention de la délivrance du brevet: **02.11.2005**
(21) Numéro de dépôt: 02783207.0
(22) Date de dépôt: 25.09.2002
(51) Int. Cl.: G01R 33/36

(54) **DISPOSITIF UNIVERSEL DE CONNEXION/RECEPTION POUR UN IMAGEUR PAR RESONANCE MAGNETIQUE NUCLEAIRE**
UNIVERSELLES VERBINDUNGS- UND EMPFANGSGERÄT FÜR EIN GERÄT ZUR BILDGEBUNG MITTELS MAGNETISCHER RESONANZ
MULTIPURPOSE CONNECTION/RECEPTION DEVICE FOR NUCLEAR MAGNETIC RESONANCE IMAGER

(30) Priorité: 26.09.2001 FR 0112361
(43) Date de publication de la demande: 28.07.2004
(73) Titulaire: UNIVERSITE CLAUDE BERNARD - LYON 1, F-69622 Villeurbanne Cédex (FR); CENTRE NATIONAL DE LA RECHERCHE SCIENTIFIQUE (CNRS), 75794 Paris Cedex 16 (FR)
(72) Inventeur: SAINT-JALMES, Hervé, F-69004 Lyon (FR); BEUF, Olivier, F-69250 MONTAGNY (FR)
(74) Mandataire: Thibault, Jean-Marc
(86) Numéro de dépôt international: PCT/FR2002/003264
(87) Numéro de publication internationale: WO 2003/027699

(56) Documents cités:
- EP-A- 0 468 857
- US-A- 5 243 289
- US-A- 5 473 252
- US-A- 5 969 526
- KASAL M ET AL: "SIGNAL PROCESSING IN TRANSCEIVERS FOR NUCLEAR MAGNETIC RESONANCE AND IMAGING" REVIEW OF SCIENTIFIC INSTRUMENTS, AMERICAN INSTITUTE OF PHYSICS. NEW YORK, US, vol. 65, no. 6, 1 juin 1994 (1994-06-01), pages 1897-1902, XP000459610 ISSN: 0034-6748

## Description

La présente invention concerne le domaine technique de l'imagerie par résonance magnétique nucléaire, ainsi que les applications de cette technique dans le domaine médical.

L'objet de l'invention vise, plus particulièrement, un dispositif universel de connexion/réception permettant d'adapter, à un imageur donné, plusieurs types de bobines de réception radiofréquence.

Les imageurs par résonance magnétique nucléaire sont, généralement, associés à un système magnétique générant un champ magnétique variable dans l'espace, dans lequel l'objet à étudier est disposé, de façon à obtenir une fréquence de résonance différente en chaque point de celui-ci. Une bobine d'émission radiofréquence est plongée dans ce champ magnétique, en vue d'émettre une onde électromagnétique qui, en fonction de la fréquence de cette onde et du champ magnétique en chaque point de l'objet à étudier, induit une résonance s'accompagnant de l'émission d'un signal magnétique. Une bobine de réception radiofréquence permet de détecter ce signal induit par la résonance et de le transformer en signal électrique. Les bobines d'émission ou de réception radiofréquence auxquelles l'invention se réfère concernent des moyens permettant de transformer des signaux électriques en onde électromagnétique pour une bobine dite d'émission ou, dans l'autre sens, pour une bobine dite de réception. Ces moyens sont aussi connus sous le nom d'antennes.

La bobine d'émission radiofréquence et la bobine de réception radiofréquence sont, généralement, reliées respectivement à un système de contrôle de l'émission radiofréquence et à un dispositif permettant la construction d'une image bi ou tridimensionnelle de l'objet à étudier, l'ensemble de ces moyens constituant un imageur par résonance magnétique nucléaire.

La bobine de réception radiofréquence est, généralement, adaptée à la forme et/ou à la taille de l'objet à étudier. Cet objet peut être n'importe quel objet observable à l'aide d'un imageur par résonance magnétique nucléaire. Il correspond, généralement, à une partie du corps d'un patient.

Par exemple, le brevet US 5 473 252 décrit un appareil d'imagerie par résonance magnétique nucléaire comportant une bobine d'émission radiofréquence et une bobine de réception radiofréquence. Afin d'augmenter le ratio signal sur bruit, l'appareil comporte une bobine localisée comprenant une antenne transformant le signal électromagnétique induit par résonance magnétique en un signal électrique transmis par un amplificateur à une antenne couplée à la bobine de réception radiofréquence.

De même, le brevet US 5 969 526 divulgue un appareil de diagnostic par résonance magnétique comportant un système de transmission-réception incluant une antenne corps entier adaptée par générer et/ou recevoir des signaux de résonance magnétique à une fréquence spécifique. Le système de transmission-réception comporte une antenne et des moyens adaptés pour mener à bien une imagerie avec des gaz hyperpolarisés.

La bobine de réception radiofréquence est souvent choisie parmi un jeu de bobines de réception radiofréquence, dites "standard" dont les caractéristiques et performances varient en fonction de la forme et/ou de la taille de l'objet à étudier.

Chaque modèle d'imageur est souvent pourvu d'un connecteur propriétaire s'adaptant avec les connecteurs provenant d'un même jeu de bobines de réception radiofréquence standard.

L'utilisateur en possession d'un modèle d'imageur ne peut généralement pas adapter des bobines de réception radiofréquence ne correspondant pas au modèle ou à la date de conception de l'imageur qu'il possède. De surcroît, un jeu de bobines de réception radiofréquence standard, correspondant à un modèle d'imageur, ne permet généralement pas de couvrir l'étendue des applications médicales qui intéressent un ensemble d'utilisateurs dans un même établissement hospitalier.

Le problème qui se pose à l'utilisateur est donc lié au manque de compatibilité ou à l'importance des investissements requis pour acquérir l'ensemble des imageurs nécessaires aux applications envisagées.

C'est justement l'objet de l'invention que de proposer un dispositif permettant de palier ce manque de compatibilité.

Pour répondre aux besoins des utilisateurs de techniques d'imagerie, l'invention vise un dispositif universel de connexion/réception pour un imageur par résonance magnétique nucléaire, conforme à la revendication 1.

Si le dispositif universel de connexion/réception décrit précédemment permet d'étendre le champ d'applications de l'utilisateur, la fréquence des ondes électromagnétiques mises en oeuvre constitue, généralement, une caractéristique invariable et prédisposée par rapport au type d'imageur utilisé. Aussi, le développement des imageurs par résonance magnétique nucléaire évolue vers l'application de champs magnétiques plus importants, ce qui induit la nécessité de changer la fréquence des ondes électromagnétiques à utiliser. De surcroît, indépendamment du champ magnétique utilisé, l'utilisateur peut être amené à envisager des fréquences de travail différentes, en fonction du type de noyau que l'on souhaite faire entrer en résonance. De ce fait, les imageurs, qui ne permettent généralement de travailler qu'à une seule fréquence, limitent encore une fois le champ d'applications envisageables.

C'est justement l'objet d'un mode particulier de réalisation de l'invention que d'utiliser un dispositif universel de connexion/réception permettant d'émettre une onde électromagnétique dont la fréquence peut être adaptée à l'application envisagée.

Ce mode de réalisation particulier vise donc un dispositif universel de connexion/réception, tel que celui décrit précédemment, caractérisé en ce qu'il comprend au moins une bobine d'émission radiofréquence indépendante, reliée à au moins une boucle de couplage d'émission assurant un couplage magnétique avec la bobine d'émission radiofréquence, et en ce qu'un synthétiseur de fréquence est interposé en sortie de la boucle de couplage d'émission et en entrée de la boucle de couplage de réception, afin d'émettre une onde électromagnétique ayant une fréquence spécifique, et d'adapter la fréquence du signal électrique issu de la bobine de réception radiofréquence indépendante à une fréquence propre de l'imageur.

Diverses autres caractéristiques ressortent de la description faite ci-dessous, en référence aux dessins annexés qui montrent, à titre d'exemples non limitatifs, des formes de réalisation et de mise en oeuvre de l'objet de l'invention.
La **fig. 1** illustre un mode de réalisation de l'invention permettant d'adapter différents types de bobines de réception radiofréquence indépendantes sur un même imageur.
La **fig. 2** illustre un autre mode de réalisation de l'invention permettant, en outre, d'émettre une onde électromagnétique ayant une fréquence spécifique et d'adapter la fréquence du signal électrique issu de la bobine de réception radiofréquence indépendante à une fréquence propre à l'imageur.

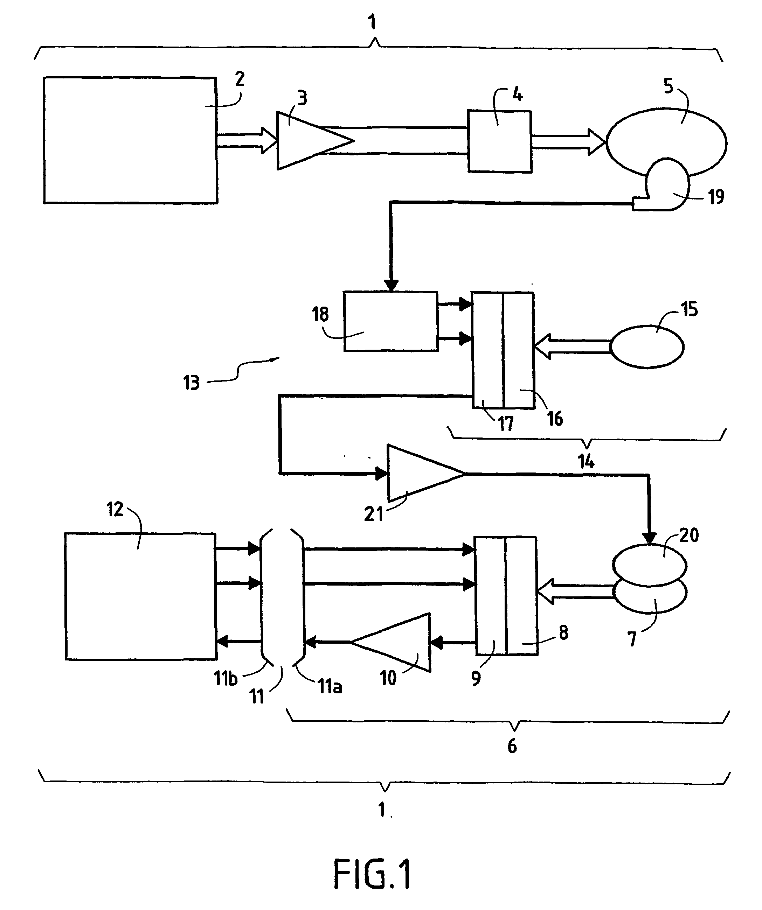

Le mode de réalisation, illustré à la **fig. 1,** permet de faire ressortir toutes les composantes constitutives d'un imageur représenté sous la référence **1.** L'une des fonctions de l'imageur **1** est l'émission d'une onde électromagnétique ayant une amplitude et une fréquence données. Cette fonction est assurée par une chaîne d'émission faisant, généralement, partie intégrante de l'imageur **1.** La chaîne d'émission comprend, en amont, un système de contrôle **2,** destiné à générer un signal électrique qui est ensuite amplifié, grâce à un amplificateur **3** relié audit système de contrôle **2.** Des moyens d'accord et d'adaptation **4** sont disposés en aval de l'amplificateur, afin d'effectuer un filtrage du signal amplifié et d'optimiser l'efficacité de l'amplification. En bout de la chaîne d'émission est connectée une bobine d'émission radiofréquence **5** permettant de transformer le signal électrique amplifié, adapté et accordé en onde électromagnétique. La bobine d'émission radiofréquence 5 est, généralement, insérée dans le champ magnétique généré par un aimant (non représenté). La bobine d'émission 5 est, dans la plupart des cas, disposée de façon à entourer, à l'intérieur de ce champ magnétique, l'objet à étudier. Les caractéristiques de l'onde électromagnétique, émise par la bobine d'émission radiofréquence **5,** sont, généralement, une fréquence substantiellement égale à 64 MHz, avec une bande passante approximativement de 200 kHz, pour un champ magnétique de 1,5 tesla. Ces caractéristiques peuvent, cependant, évoluer en fonction du champ magnétique utilisé, ainsi que du type d'analyse effectué.

L'imageur **1** peut comprendre des moyens permettant d'adapter différents types de bobines d'émission radiofréquence. Il peut comprendre, en outre, d'autres moyens permettant d'ajuster les paramètres de réglage des moyens d'accord et d'adaptation **4,** ainsi que de l'amplificateur **3**.

Comme cela est représenté à la **fig. 1,** l'imageur **1** comprend au moins une bobine de réception radiofréquence standard **6.** La bobine de réception radiofréquence standard **6** peut elle-même comprendre une bobine à proprement dit 7, des moyens d'accord et d'adaptation **8** et des moyens de découplage **9**. Elle peut comprendre, également, un préamplificateur **10**.

La bobine de réception radiofréquence standard **6** fait, généralement, partie d'un jeu de bobines de réception radiofréquence standard dont chacune d'entre elles est munie d'un connecteur standard **11a** qui est adaptable au connecteur **11b** du modèle d'imageur utilisé. La connectique **11** de ces bobines de réception radiofréquence standard associée à un modèle d'imageur peut varier en fonction du modèle et de la date de conception de ladite bobine et/ou de l'imageur utilisé.

L'imageur **1** comprend, également, un récepteur radiofréquence **12** muni du connecteur **11b** permettant de recevoir le signal électrique provenant d'une bobine de réception radiofréquence standard.

L'imageur **1** comprend, bien évidemment, des moyens de traitement numériques (non représentés) permettant de construire des images bi ou tridimensionnelles de l'objet à étudier.

Conformément à l'invention, l'imageur par résonance magnétique nucléaire est associé à un dispositif universel de connexion/réception **13** comprenant au moins une bobine de réception radiofréquence indépendante **14**. Cette bobine est indépendante, du fait qu'elle ne constitue pas une composante de l'imageur **1**, telle qu'il a été définie précédemment. La bobine de réception radiofréquence indépendante **14** est équipée d'une bobine à proprement dite **15** permettant de transformer le signal induit par la résonance en signal électrique. Cette bobine **14,** et en particulier la bobine à proprement dite **15,** est adaptée à la forme et/ou à la taille d'un objet à étudier. La bobine de réception radiofréquence indépendante peut être positionnée de façon à entourer l'objet à étudier. Elle peut, également, être positionnée à proximité de l'objet à étudier. Elle est généralement, comme l'objet à étudier, disposée à l'intérieur du champ magnétique généré par l'aimant associé à l'imageur. De surcroît, elle peut être, avantageusement, disposée à l'intérieur de la bobine d'émission radiofréquence **5.**

De préférence, la bobine de réception radiofréquence indépendante **14** comprend des moyens d'accord et d'adaptation **16,** auxquels la bobine proprement dite **15** est rattachée. En particulier, cette bobine de réception radiofréquence indépendante **14** peut comprendre des moyens de découplage **17.** Ces moyens de découplage **17,** appelés aussi dispositifs d'isolement, permettent de minimiser les couplages entre la bobine d'émission radiofréquence **5** et la bobine de réception radiofréquence indépendante **14.** Ce couplage a, en effet, deux conséquences néfastes :
- la première est le renforcement du champ induit par l'onde électromagnétique d'émission, la bobine de réception radiofréquence indépendante **14** jouant alors le rôle de concentrateur de flux magnétique ce qui perturbe le fonctionnement normal de l'imageur,
- et la seconde est provoquée par un échauffement inacceptable de l'objet à étudier qui, dans le domaine médical, correspond généralement à la partie du corps d'un patient, ce qui met en danger le patient si une certaine limite est dépassée.

Un circuit électronique de contrôle **18** est relié aux moyens de découplage **17,** et selon un mode avantageux de réalisation, le circuit est également relié aux moyens d'accord et d'adaptation. Le circuit électronique de contrôle **18** permet, notamment, d'ajuster les moyens d'accord et d'adaptation **16** et les moyens de découplage **17.**

Le dispositif comprend une boucle de surveillance **19,** assurant un couplage magnétique avec la bobine d'émission radiofréquence **5,** et reliée au circuit électronique de commande **18.** La boucle de surveillance **19** permet, notamment, d'asservir les moyens de découplage **17** de la bobine de réception radiofréquence indépendante **14** par rapport à l'onde électromagnétique émise par la bobine d'émission radiofréquence **5,** et ceci par l'intermédiaire du circuit électronique **18.**

Le couplage magnétique de la boucle de surveillance **19** avec la bobine d'émission radiofréquence **5** peut être réalisé de n'importe quelle façon. Ce couplage permet de transférer, sous forme d'un signal électrique, l'onde électromagnétique émise par la bobine d'émission radiofréquence **5** vers le circuit électronique de commande **18.**

Selon un mode de réalisation particulier, la bobine de réception radiofréquence indépendante **14** est choisie parmi les bobines de réception radiofréquence standard disponibles sur le marché.

Conformément à l'invention, la bobine de réception radiofréquence indépendante **14** est reliée à une boucle de couplage de réception **20,** assurant un couplage magnétique avec la bobine de réception radiofréquence standard **6**.

Il s'ensuit que, pour un même imageur, il est possible d'utiliser n'importe quel type de bobine de réception radiofréquence indépendante **14,** quels que soient le modèle et la date de conception de celle-ci.

La boucle de couplage de réception **20** peut être positionnée à proximité, ou de préférence, à l'intérieur de la bobine de réception radiofréquence standard **7** à proprement dit.

Généralement, la boucle de couplage de réception **20** et la bobine de réception radiofréquence standard **6** sont toutes les deux localisées en dehors du champ magnétique généré par l'aimant associé à l'imageur. Dans ce cas, la fonction de la boucle de couplage de réception **20** est de transférer un signal électrique provenant de la bobine de réception radiofréquence indépendante **14.**

Selon un autre mode d'utilisation, la boucle de couplage de réception **20** et la bobine de réception radiofréquence standard **6** sont localisées à l'intérieur du champ magnétique généré par l'aimant associé à l'imageur. La boucle de couplage de réception **20** et la bobine **7** ont alors pour fonctions, non seulement le transfert d'un signal électrique provenant de la bobine de réception radiofréquence indépendante **14**, mais aussi la réception du signal électromagnétique induit par résonance magnétique nucléaire de l'objet à étudier.

De préférence, un préamplificateur de couplage **21** est inséré entre la bobine de réception radiofréquence indépendante **14** et la boucle de couplage de réception **20.**

Il est possible d'envisager un dispositif ayant plusieurs bobines de réception radiofréquence indépendantes **14,** connectées par un couplage magnétique grâce à autant de boucles de couplage de réception **20** avec autant de bobines de réception radiofréquence standard **6,** elles-mêmes reliées à l'imageur.

Selon un mode particulier de l'invention, deux bobines de réception radiofréquence indépendantes **14,** disposées en quadrature, sont reliées à deux boucles de couplage de réception **20** assurant un couplage magnétique avec deux bobines de réception radiofréquence standard **6** de l'imageur **1**. La disposition des bobines de réception radiofréquence indépendantes **14** en quadrature signifie que chacune d'entre elles est disposée de façon à ce que les axes principaux des champs forment un angle approximativement égal à 90°. Il est généralement nécessaire, dans ce cas particulier, de prévoir un dispositif permettant d'additionner les signaux électriques provenant des bobines de réception radiofréquence standard **6**.

Selon un mode différent du mode de réalisation précédent, deux bobines de réception radiofréquence indépendantes **14**, disposées en quadrature, sont reliées aux entrées d'un dispositif additionneur (non représenté) comprenant au moins deux entrées et une sortie, ladite sortie étant reliée à la boucle de couplage de réception **20**. Ce mode de réalisation permet de n'utiliser qu'une seule boucle de couplage de réception **20** et qu'une seule bobine de réception radiofréquence standard **6.** Il est à noter qu'il peut être envisagé d'utiliser un nombre supérieur à deux bobines de réception radiofréquence indépendantes **14.**

Selon un mode particulier de réalisation de l'invention, le dispositif universel de connexion/réception permet d'émettre une onde électromagnétique à une fréquence spécifique différente de la fréquence propre de l'imageur et d'adapter la fréquence du signal électrique, issu de la bobine de réception radiofréquence indépendante **14**, à la fréquence propre de l'imageur. Cela permet, en outre, de faire entrer en résonance des noyaux autres que ceux des atomes d'hydrogène, dont la fréquence de résonance est approximativement de 42 MHz, pour un champ magnétique de 1 tesla. De ce fait, il peut être envisagé de faire entrer en résonance des noyaux de molécules tels que, par exemple, le phosphore ou l'hélium. De plus, l'évolution dans le domaine de l'imagerie par résonance magnétique nucléaire tend à utiliser des champs magnétiques plus élevés, par exemple 3 teslas, de sorte que les fréquences des ondes électromagnétiques émises doivent être réadaptées.

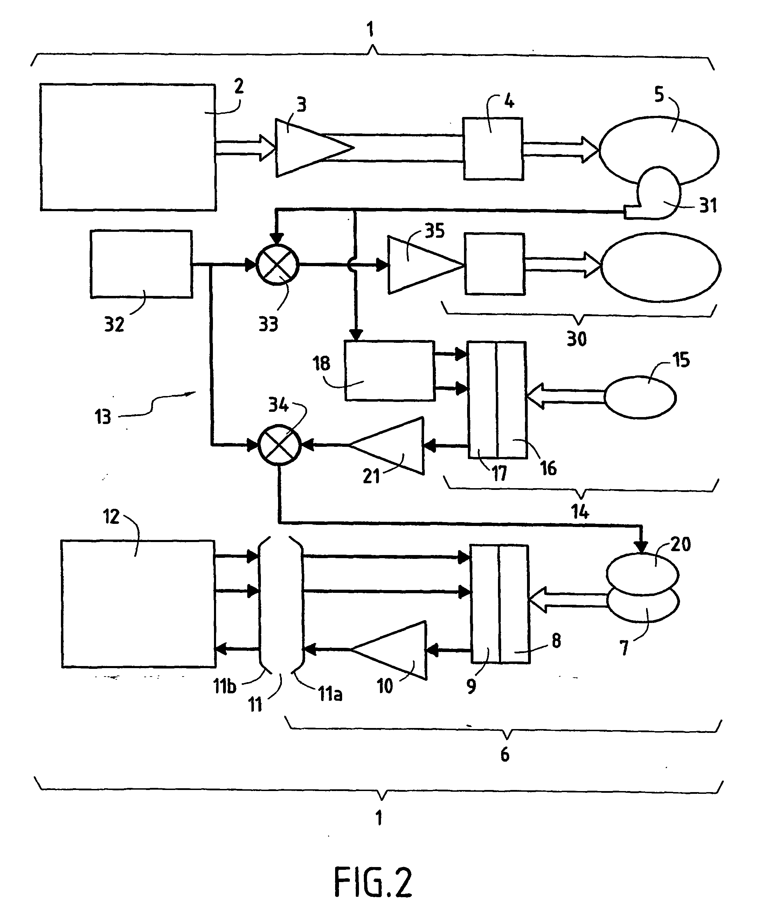

Comme cela est illustré à la **fig. 2,** selon ce mode particulier de réalisation de l'invention, le dispositif universel de connexion/réception **13** comprend au moins une bobine d'émission radiofréquence indépendante **30,** reliée à au moins une boucle de couplage d'émission **31** assurant un couplage magnétique avec la bobine d'émission radiofréquence **5.** Le dispositif universel de réception **13** comprend, en outre, un synthétiseur de fréquence **32,** interposé en sortie de la boucle de couplage d'émission **31** et en entrée de la boucle de couplage de réception **20.** Le synthétiseur de fréquence **32** permet d'émettre une onde électromagnétique, ayant une fréquence spécifique, et d'adapter la fréquence du signal électrique issu de la bobine de réception radiofréquence indépendante **14** à une fréquence propre de l'imageur **1**. Le synthétiseur de fréquence **32** est interposé en sortie de la boucle de couplage d'émission **31** grâce à un dispositif adaptateur de fréquence **33** permettant de transformer la fréquence du signal électrique, qui est propre à l'imageur 1, en une fréquence spécifique. De la même façon, le synthétiseur **32** est interposé en entrée de la boucle de couplage de réception **20** grâce à un autre dispositif adaptateur de fréquence **34** (tel qu'un mélangeur par exemple) permettant d'adapter la fréquence dm signal électrique, issu de la bobine de réception radiofréquence indépendante **14**, à une fréquence propre de l'imageur **1**.

Selon un mode préférentiel, le dispositif adaptateur de fréquence **33** est relié à la bobine d'émission radiofréquence indépendante **30** par l'intermédiaire d'un amplificateur **35.**

Selon un autre mode préférentiel, la bobine d'émission radiofréquence indépendante **30** comprend des moyens d'accord et d'adaptation.

L'invention permet, avantageusement, d'utiliser des ondes électromagnétiques dont la fréquence peut être adaptée à une fréquence spécifique, différente de la fréquence propre de l'imageur. Cela permet de faire entrer en résonance des noyaux d'atomes autres que l'hydrogène, tels que par exemple le phosphore ou l'hélium. Cela permet, en outre, d'adapter la fréquence des ondes électromagnétiques à des champ magnétiques supérieurs à ceux couramment utilisés.

L'invention n'est pas limitée aux exemples décrits et représentés car diverses modifications peuvent y être apportées sans sortir de son cadre.

## Revendications

1. Dispositif universel de connexion/réception pour un imageur **(1)** par résonance magnétique nucléaire muni d'au moins une bobine d'émission radiofréquence **(5)** et d'au moins une bobine de réception radiofréquence standard **(6),** ce dispositif comportant au moins une bobine de réception radiofréquence indépendante **(14),** adaptée à la forme et/ou à la taille d'un objet à étudier, destinée à transfornner en signal électrique un signal électromagnétique induit par résonance magnétique nucléaire, ladite bobine de réception radiofréquence indépendante **(14)** étant reliée à une boucle de couplage de réception **(20)** assurant un couplage magnétique avec la bobine de réception radiofréquence standard **(6), caractérisé en ce qu'**il comprend une boucle de surveillance **(19),** assurant un couplage magnétique avec la bobine d'émission radiofréquence **(2),** et reliée par un circuit électronique de contrôle **(18)** à des moyens de découplage **(17)** de la bobine de réception radiofréquence indépendante **(14),** de manière à asservir les moyens de découplage **(17)** par rapport à l'onde électromagnétique émise par la bobine d'émission radiofréquence **(5),** les moyens de découplage **(17)** permettant de minimiser des couplages entre la bobine d'émission radiofréquence **(5)** et la bobine de réception indépendante **(14)**.

2. Dispositif selon la revendication 1, **caractérisé en ce qu'**un préamplificateur de couplage **(21)** est inséré, entre la bobine de réception radiofréquence indépendante **(14)** et la boucle de couplage de réception **(20)**.

3. Dispositif selon la revendication 1 ou 2, **caractérisé en ce que** la bobine de réception radiofréquence indépendante **(14)** comprend des moyens d'accord et d'adaptation **(16)** relié au circuit électronique de contrôle **(18)**.

4. Dispositif selon l'une quelconque des revendications 1 à 3, **caractérisé en ce que** deux bobines de réception radiofréquence indépendantes **(14)** disposées en quadrature sont reliées à deux boucles de couplage de réception **(20)** assurant un couplage magnétique avec deux bobines de réception radiofréquence standards **(6)** de l'imageur **(1)**.

5. Dispositif selon l'une quelconque des revendications 1 à 4, **caractérisé en ce que** deux bobines de réception radiofréquence indépendantes **(14)** disposées en quadrature, sont reliées aux entrées d'un dispositif additionneur comprenant au moins deux entrées et une sortie, ladite sortie étant reliée à la boucle de couplage de réception **(20).**

6. Dispositif selon l'une quelconque des revendications 1 à 5, **caractérisé en ce qu'**il comprend au moins une bobine d'émission radiofréquence indépendante **(30),** reliée à au moins une boucle de couplage d'émission **(31)** assurant un couplage magnétique avec la bobine d'émission radiofréquence **(5),** et **en ce qu'**un synthétiseur de fréquence **(32)** est interposé en sortie de la boucle de couplage d'émission **(31)** et en entrée de la boucle de couplage de réception **(20),** afin d'émettre une onde électromagnétique ayant une fréquence spécifique, et d'adapter la fréquence du signal électrique issu de la bobine de réception radiofréquence indépendante **(14)** à une fréquence propre de l'imageur **(1)**.

7. Dispositif selon la revendication 6, **caractérisé en ce que** la bobine d'émission radiofréquence indépendante **(30)** est alimentée par l'intermédiaire d'un amplificateur **(35)** qui s'interpose entre la boucle de couplage d'émission **(31)** et ladite bobine d'émission radiofréquence indépendante **(30)**.

8. Dispositif selon l'une quelconque des revendications 6 et 7, **caractérisé en ce que** la bobine d'émission radiofréquence indépendante (30) comprend des moyens d'accord et d'adaptation.

9. Imageur par résonance magnétique nucléaire muni d'au moins une bobine d'émission radiofréquence **(5)** et d'au moins une bobine de réception radiofréquence standard (6), comportant un dispositif universel de connexion/réception conforme à l'une des revendications 1 à 8.

10. Imageur selon la revendication 9, la boucle de couplage de réception (20) étant positionnée à l'intérieur de la bobine de réception radiofréquence standard (6).

11. Imageur selon l'une quelconque des revendications 9 et 10, la boucle de couplage de réception (20) et la bobine de réception radiofréquence standard (6) étant localisées à l'intérieur d'un champ magnétique généré par un aimant de l'imageur.

## Patentansprüche

1. Universelle Verbindungs-/Empfangseinrichtung für ein Gerät zur Bildgebung (1) mittels kernmagnetischer Resonanz, das mit wenigstens einer Radiofrequenzsendespule (5) und mit wenigstens einer Standard-Radiofrequenzempfangsspule (6) ausgestattet ist, wobei diese Vorrichtung wenigstens eine selbständige Radiofrequenzempfangsspule (14) umfaßt, die an die Form und/oder an die Größe eines zu untersuchenden Objektes anpaßt und dazu bestimmt ist, ein durch kernmagnetische Resonanz induziertes elektromagnetisches Signal in ein elektrisches Signal umzuwandeln, wobei die selbständige Radiofrequenzempfangsspule (14) mit einer Empfangskopplungsschleife (20) verbunden ist, welche eine magnetische Kopplung mit der Standard-Radiofrequenzempfangsspule (6) sicherstellt, **dadurch gekennzeichnet, daß** sie eine Überwachungsschleife (19) umfaßt, die eine magnetische Kopplung mit der Radiofrequenzsendespule (2) sicherstellt und die über einen elektronischen Kontrollkreis (18) mit Entkopplungsmitteln (17) der selbständigen Radiofrequenzempfangsspule (14) verbunden ist, derart, daß die Entkopplungsmittel (17) der durch die Radiofrequenzsendespule (5) ausgesandten elektromagnetischen Welle untergeordnet werden, wobei die Entkopplungsmittel (17) ermöglichen, Kopplungen zwischen der Radiofrequenzsendespule (5) und der selbständigen Empfangsspule (14) zu minimieren.

2. Einrichtung nach Anspruch 1, **dadurch gekennzeichnet, daß** ein Kopplungsvorverstärker (21) zwischen der selbständigen Radiofrequenzempfangsspule (14) und der Empfangskopplungsschleife (20) eingefügt ist.

3. Einrichtung nach Anspruch 1 oder 2, **dadurch gekennzeichnet, daß** die selbständige Radiofrequenzempfangsspule (14) Mittel zur Abstimmung und Anpassung (16) umfaßt, die mit dem elektronischen Kontrollkreis (18) verbunden sind.

4. Einrichtung nach irgendeinem der Ansprüche 1 bis 3, **dadurch gekennzeichnet, daß** zwei selbständige, in Quadratur angeordnete Radiofrequenzempfangsspulen (14) mit zwei Empfangskopplungsschleifen (20) verbunden sind, die eine magnetische Kopplung mit zwei Standard-Radiofrequenzempfangsspulen (6) des Bildgebungsgerätes (1) sicherstellen.

5. Einrichtung nach irgendeinem der Ansprüche 1 bis 4, **dadurch gekennzeichnet, daß** zwei selbständige, in Quadratur angeordnete Radiofrequenzempfangsspulen (14) mit den Eingängen einer Additionseinrichtung verbunden sind, die wenigstens zwei Eingänge und einen Ausgang umfaßt, wobei der genannte Ausgang mit der Empfangskopplungsschleife (20) verbunden ist.

6. Einrichtung nach irgendeinem der Ansprüche 1 bis 5, **dadurch gekennzeichnet, daß** sie wenigstens eine selbständige Radiofrequenzsendespule (30) umfaßt, die mit wenigstens einer Sendekopplungsschleife (31) verbunden ist, welche eine magnetische Kopplung mit der Radiofrequenzsendespule (5) sicherstellt, und daß ein Frequenzaufbereitungsteil (32) am Ausgang der Sendekopplungsschleife (31) und am Eingang der Empfangskopplungsschleife (20) eingefügt ist, um eine elektromagnetische Welle mit einer speziellen Frequenz auszusenden und um die Frequenz des aus der selbständigen Radiofrequenzempfangsspule (14) stammenden elektrischen Signals an eine Eigenfrequenz des Bildgebungsgerätes (1) anzupassen.

7. Einrichtung nach Anspruch 6, **dadurch gekennzeichnet, daß** selbständige Radiofrequenzsendespule (30) mittels eines Verstärkers (35) gespeist wird, der zwischen der Sendekopplungsschleife (31) und der selbständigen Radiofrequenzsendespule (30) zwischengeschaltet ist.

8. Einrichtung nach irgendeinem der Ansprüche 6 und 7, **dadurch gekennzeichnet, daß** die selbständige Radiofrequenzsendespule (30) Mittel zur Abstimmung und Anpassung umfaßt.

9. Gerät zur Bildgebung mittels kernmagnetischer Resonanz, das mit wenigstens einer Radiofrequenzsendespule (5) und mit wenigstens einer Standard-Radiofrequenzempfangsspule (6) ausgestattet ist und eine universelle Verbindungs-/Empfangseinrichtung gemäß einem der Ansprüche 1 bis 8 aufweist.

10. Bildgebungsgerät nach Anspruch 9, wobei die Empfangskopplungsschleife (20) innerhalb der Standard-Radiofrequenzempfangsspule (6) angeordnet ist.

11. Bildgebungsgerät nach irgendeinem der Ansprüche 9 und 10, wobei die Empfangskopplungsschleife (20) und die Standard-Radiofrequenzempfangsspule (6) innerhalb eines durch einen Magneten des Bildgebungsgerätes erzeugten Magnetfeldes angeordnet sind.

## Claims

1. Universal connection/reception device for an imager (1) by nuclear magnetic resonance provided with at least one radiofrequency emitting coil (5) and at least one standard radiofrequency receiving coil (6), this device including at least one independent radiofrequency receiving coil (14), adapted to the shape and/or the size of an object to be investigated, intended for converting an electrical signal into an electromagnetic signal induced by nuclear magnetic resonance, said independent radiofrequency receiving coil (14) being connected to a receiving coupling loop (20) providing magnetic coupling with the standard radiofrequency receiving coil (6), **characterized in that** it comprises a monitoring loop (19), providing magnetic coupling with the radiofrequency emitting coil (2) and connected through a control electronic circuit (18) to decoupling means (17) of the independent radiofrequency receiving coil (14), so as to control the decoupling means (17) relatively to the electromagnetic wave emitted by the radiofrequency emitting coil (5), the decoupling means (17) providing minimization of couplings between the radiofrequency emitting coil (5) and the independent receiving coil (14).

2. The device according to claim 1, **characterized in that** a coupling preamplifier (21) is inserted between the independent radiofrequency receiving coil (14) and the receiving coupling loop (20).

3. The device according to claim 1 or 2, **characterized in that** the independent radiofrequency receiving coil (14) comprises tuning and adaptation means (16) connected to the control electronic circuit (18).

4. The device according to any of claims 1 to 3, **characterized in that** two independent radiofrequency receiving coils (14) positioned in quadrature are connected to two receiving coupling loops (20) providing magnetic coupling with two standard radiofrequency receiving coils (6) of the imager (1) .

5. The device according to any of claims 1 to 4, **characterized in that** two independent radiofrequency receiving coils (14) positioned in quadrature, are connected to the inputs of an adder device comprising at least two inputs and one output, said output being connected to the receiving coupling loop (20).

6. The device according to any of claims 1 to 5, **characterized in that** it comprises at least one independent radiofrequency emitting coil (30), connected to at least one emitting coupling loop (31) providing magnetic coupling with the radiofrequency emitting coil (5) and **in that** a frequency synthetizer (32) is interposed at the output of the emitting coupling loop (31) and at the input of the receiving coupling loop (20), in order to emit an electromagnetic wave with a specific frequency, and to adapt the frequency of the electrical signal from the independent radiofrequency receiving coil (14) to an eigenfrequency of the imager (1).

7. The device according to claim 6, **characterized in that** the independent radiofrequency emitting coil (30) is powered via an amplifier (35) which is interposed between the emitting coupling loop (31) and said independent radiofrequency emitting coil (30).

8. The device according to any of claims 6 and 7, **characterized in that** the independent frequency emitting coil (30) comprises tuning and adaptation means.

9. A nuclear magnetic resonance imager provided with at least one radiofrequency emitting coil (5) and at least one standard radiofrequency receiving coil (6) including a universal connection/reception device according to any of claims 1 to 8.

10. The imager according to claim 9, the receiving coupling coil (20) being positioned inside the standard radiofrequency receiving coil (6).

11. The imager according to any of claims 9 and 10, the receiving coupling coil (20) and the standard radiofrequency receiving coil (6) being localized inside a magnetic field generated by a magnet of the imager.
